# FASCICULE DE BREVET EUROPEEN

(11) **EP 0 626 760 B1**
(45) Date de publication et mention de la délivrance du brevet: **05.03.2003**
(21) Numéro de dépôt: 94810292.6
(22) Date de dépôt: 20.05.1994
(51) Int. Cl.: H03K 19/177, G06F 11/20

(54) **Système électronique organisé en réseau matriciel de cellules**
Als Zellenmatrix-Netzwerk organisiertes elektronisches System
Electronic system organized in matrix cell network

(30) Priorité: 24.05.1993 CH 155593
(43) Date de publication de la demande: 30.11.1994
(73) Titulaire: CSEM, Centre Suisse d'Electronique et de Microtechnique S.A., 2007 Neuchâtel (CH)
(72) Inventeur: Mange, Daniel, CH-1025 Saint-Sulpice (CH); Sanchez, Eduardo, CH-1025 Saint-Sulpice (CH); Marchal, Pierre, CH-1007 Lausanne (CH); Piguet, Christian, CH-2007 Neuchâtel (CH)
(74) Mandataire: Brulliard, Joel

(56) Documents cités:
- WO-A-85/02730
- WO-A-88/03727
- US-A- 4 047 163
- US-A- 4 700 187
- US-A- 4 935 734
- US-A- 5 208 491
- IEICE TRANSACTIONS ON ELECTRONICS, vol. E75-C, no. 4, Avril 1992, TOKYO, JP, pages 413-426, XP000301671 A.S. SHUBAT ET AL.: "A Family of User-Programmable Peripherals with a Functional Unit Architecture"

## Description

La présente invention se rapporte aux systèmes électroniques intégrés programmables en général et concerne, en particulier, de tels systèmes qui sont organisés en réseau matriciel de cellules identiques et disposent, intrinsèquement, d'une capacité de reprogrammation lors de panne d'une ou plusieurs des cellules constituant ledit système.

A côté des circuits intégrés de type "ASIC" (Application Specific Integrated Circuits), qui sont destinés à réaliser une fonction spécifique à une application et nécessitent un temps de développement important et des circuits de type "Gâte Array", qui sont constitués par un réseau de portes logiques et peuvent être configurés, à l'aide d'un ou deux masques d'interconnexions, pour satisfaire à un cahier des charges donné, est apparu, ces dernières années, un nouveau type de circuits intégrés connu sous l'appelation "FPGA" (Field-Programmable Gate Array). Ces circuits "FPGA", dont une description peut être trouvée dans le livre édité sous le titre "Field-Programmable Gate Arrays" par les éditions "Kluwer Academic Publishers", sont des systèmes logiques programmables pouvant présenter une grande complexité. Ils sont constitués d'un ensemble de blocs logiques et d'éléments de connexion (interrupteurs programmables) permettant d'assembler lesdits blocs logiques selon une configuration qui satisfait à un cahier des charges donné. Pour utiliser de tels systèmes, il est nécessaire d'élaborer, à partir du cahier des charges de l'application envisagée, un schéma logique avec des modules prédéfinis et de transformer, à l'aide d'un outil logiciel convenable, ce schéma logique en une série de connexions réparties au sein du substrat de silicium et reliant les différents blocs logiques de manière à permettre au système de fonctionner selon ledit cahier des charges. Bien que plus performants que les "Gate Arrays", car les blocs logiques peuvent réaliser des fonctions plus complexes, les "FPGA" procèdent toutefois de la même démarche que les premiers; à savoir, les cellules sont déterminées à priori et le programme, qui permet leurs interconnexions et est défini à partir du cahier des charges de l'application, est stocké une fois pour toutes dans la mémoire du système ou dans les interrupteurs qui définissent la fonction du système. Il n'existe, dans ces types de circuits, aucune possibilité de réparation en cas de panne d'un des éléments fonctionnels.

Aussi un objet de la présente invention est un système programmable qui ne présente pas les inconvénients mentionnés ci-dessus.

Un autre objet de l'invention est un système programmable constitué par un réseau de cellules identiques et comportant des moyens pour stocker la fonction du réseau et des moyens pour déterminer, à partir de la fonction du réseau, la fonction de chaque cellule en prenant en compte la position de ladite cellule et son environnement.

Encore un autre objet de l'invention est un système programmable qui comporte un réseau de cellules et des moyens de détecter celles de ses cellules qui sont défectueuses.

Encore un autre objet de l'invention est un système programmable, comportant un réseau de cellules, des moyens de détection des cellules défectueuses et des moyens pour reconfigurer ledit réseau en désactivant lesdites cellules défectueuses.

Ces objets sont réalisés grâce aux caractéristiques exposées dans les revendications attachées à la présente description.

Un avantage particulièrement intéressant de la présente invention réside dans la possibilité intrinsèque de reconfiguration du réseau en cas de panne d'une ou plusieurs cellules; ce qui accroît considérablement la fiabilité du système. Il existe nombre d'applications, tels les systèmes électroniques embarqués, pour lesquelles cette possibilité de reconfiguration constituerait un atout très important.

D'autres objets, caractéristiques et avantages de la présente invention apparaîtront plus clairement à la lecture de la description suivante d'exemples de réalisation particuliers, ladite description étant faite à titre purement illustratif et en relation avec les dessins joints dans lesquels:
- la figure 1 montre un algorithme de décision binaire pour la fonction dite fonction "majorité";
- la figure 2 montre un exemple d'implémentation de la fonction majorité à l'aide d'un réseau de cellules identiques constituées par des circuits multiplexeurs;
- la figure 3 montre une cellule du réseau de la figure 2;
- la figure 4 est un bloc-diagramme d'un exemple de circuit permettant la reconstitution du gène de la cellule;
- la figure 5 montre un autre réseau de cellules disposant de moyens de programmation uniques et de moyens de reconfiguration en cas de panne d'une cellule;
- la figure 6 montre un algorithme de génération des gènes des cellules du réseau de la figure 5;
- la figure 7 montre une autre variante de reconfiguration du réseau en cas de panne d'une cellule; et
- la figure 8 montre un circuit permettant la désactivation d'une cellule de la ligne d'une cellule défectueuse.

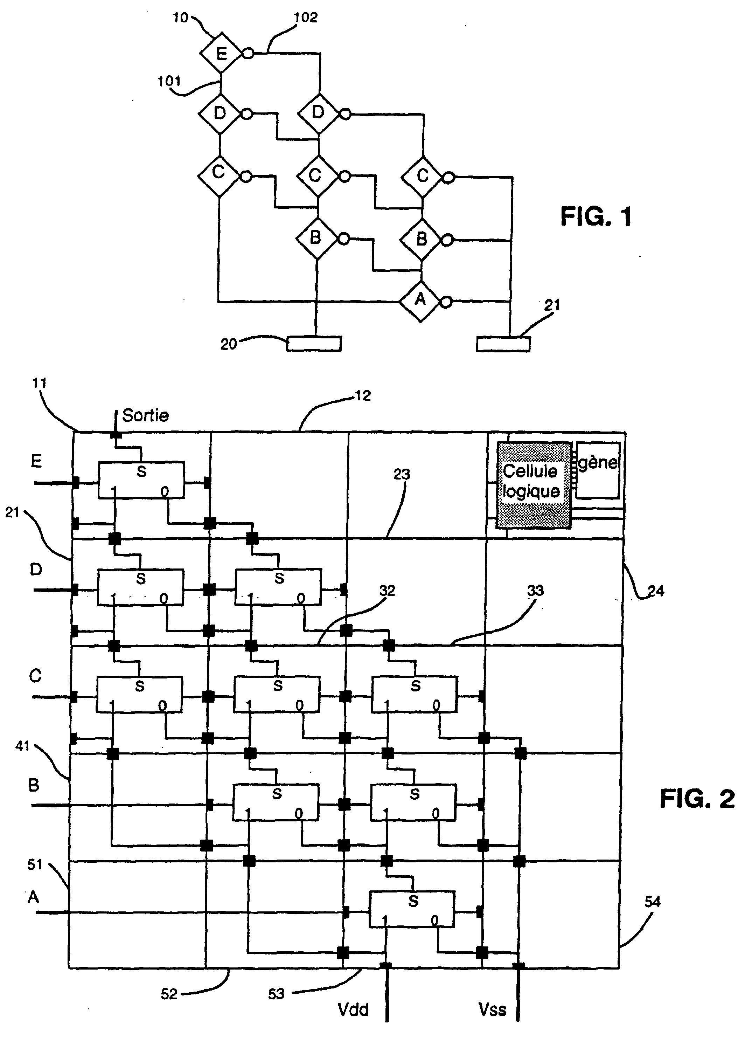

Le schéma de la figure 1 montre un exemple d'algorithme de décision binaire. Cet algorithme est représentatif d'une fonction dite fonction "majorité" qui présente un état logique "1" en sortie si au moins trois des cinq variables A, B, C, D et E est dans un état logique "1". Chaque losange représente une opération de test sur la variable dont le nom figure à l'intérieur. Ainsi le losange 10 représente une opération de test de la variable E qui active, soit la sortie 101 si la variable E est dans l'état logique "1", soit la sortie 102 si la variable E est dans l'état logique "0". Les rectangles 20 et 21 représentent les fonctions "*Mettre la sortie S dans l'état 1*" et *"Mettre la sortie S dans l'état 0",* respectivement. Selon cet algorithme, la sortie S prend la valeur logique "1" lorsque trois au moins des variables A, B, C, D et E sont simultanément dans l'état logique "1" et elle prend la valeur logique "0" dans les autres cas.

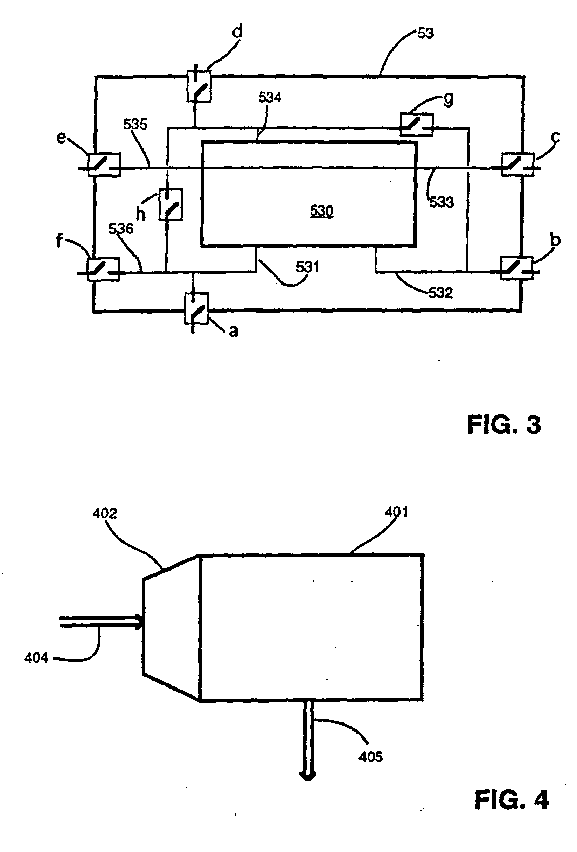

Un exemple d'implémentation "hardware" de l'algorithme de la figure 1, à l'aide d'un réseau de cellules identiques, est montré à la figure 2. Chaque cellule réalise une opération de test sur une variable et est réalisée à l'aide d'un circuit multiplexeur à deux entrées et une sortie. On remarquera que l'architecture de ce réseau recopie fidèlement la représentation de l'algorithme montré à la figure 1. Ainsi trouve-t-on un premier niveau ne comportant qu'un multiplexeur (test de la variable A), suivi d'un deuxième niveau comportant deux multiplexeurs (test de la variable B), puis un troisième niveau comportant trois multiplexeurs (test de la variable C), un quatrième niveau comportant deux multiplexeurs (test de la variable D) et, enfin, un cinquième niveau ne comportant qu'un seul multiplexeur (test de la variable E). Chaque cellule, par exemple la cellule 53 (représentée à la figure 3), comporte un multiplexeur 530 ayant une première entrée 531 et une deuxième entrée 532, une entrée de test 533, une sortie 534 et une deuxième entrée de test, reliée à la première, 535. Pour que le réseau de la figure 2 satisfasse aux caractéristiques de l'invention, il faut que chaque cellule dispose de moyens de programmation propres, de manière à ce qu'elle puisse être configurée de façon à remplir la bonne fonction. Ces moyens de programmation sont constitués par des premiers interrupteurs a, b, c, d, e et f qui assurent les connexions de cellule à cellule et par des seconds interrupteurs g et h qui permettent d'effectuer certaines connexions internes aux cellules et requises pour certaines d'entre elles. Dans les cellules, telle la cellule 32, les premiers interrupteurs a à f sont tous fermés, tandis que les seconds interrupteurs g et h sont ouverts. Dans les cellules, telle la cellule 54, seuls les interrupteurs a, d, f et h sont fermés, les autres interrupteurs restant ouverts. Dans les cellules, telle la cellule 52, ce sont les interrupteurs c, e et g seulement qui sont fermés. Dans les cellules, telle la 23, seuls les interrupteurs a et f sont fermés. Dans les cellules, telle la cellule 33, ce sont les interrupteurs a, b, d, e et f qui sont fermés. Dans la cellule 51, seuls les interrupteurs c et e sont fermés. Dans les cellules, telle la cellule 24, tous les interrupteurs a à h sont ouverts. Ainsi pour le réseau de la figure 2, huit interrupteurs sont suffisants pour programmer chaque cellule de manière à ce qu'elle remplisse l'une des sept fonctions différentes possibles.

Selon une caractéristique de l'invention, cette programmation s'effectue à partir d'une information (ou génome) mémorisée, représentant la fonction du réseau et qui est commune à toutes les cellules, d'une part, et du code de la cellule qui est propre à cette dernière, d'autre part. La figure 4 montre un bloc-diagramme d'un circuit 400 permettant la détermination de la fonction d'une cellule à partir du génome du réseau. Le génome du réseau est mémorisé dans une mémoire de type RAM 401. Cette mémoire est adressée par le code de la cellule, appliqué sur les entrées 404 du générateur d'adresses 402, et délivre un mot de programmation de la fonction de la cellule sur sa sortie 405. S'agissant du réseau de la figure 2, ce mot de programmation (ou gène) de la cellule est un mot de huit bits permettant de programmer les huit interrupteurs mentionnés ci-dessus. Selon une première variante, chaque cellule du réseau détient le génome de tout le réseau et les moyens de déterminer son propre gène, définissant sa fonction, à partir de son propre code. Selon une autre variante, le génome est stocké dans une mémoire extérieure à la cellule et chaque cellule est à même d'adresser la mémoire en lui appliquant son propre code et de lire son propre gène. Le code de chaque cellule peut être constitué par ses coordonnées dans le réseau. On peut, dès lors, aisément reconfigurer le réseau en changeant les coordonnées des cellules. Cela peut, notamment, être rendu nécessaire en cas de panne constatée d'une ou plusieurs cellules du réseau.

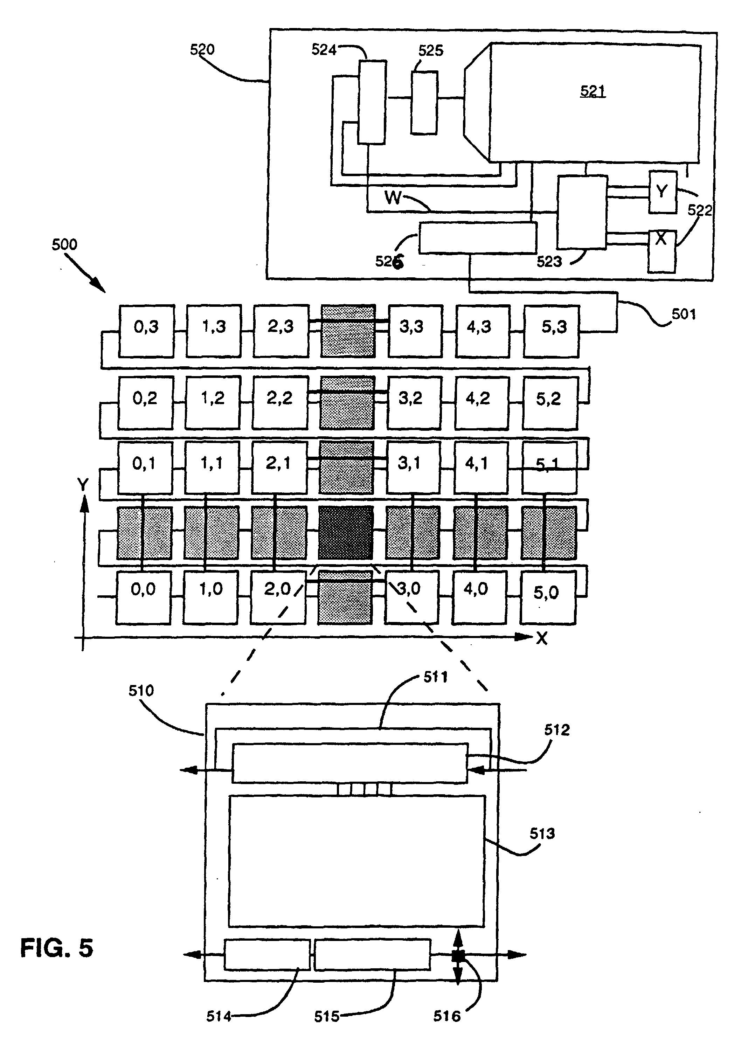

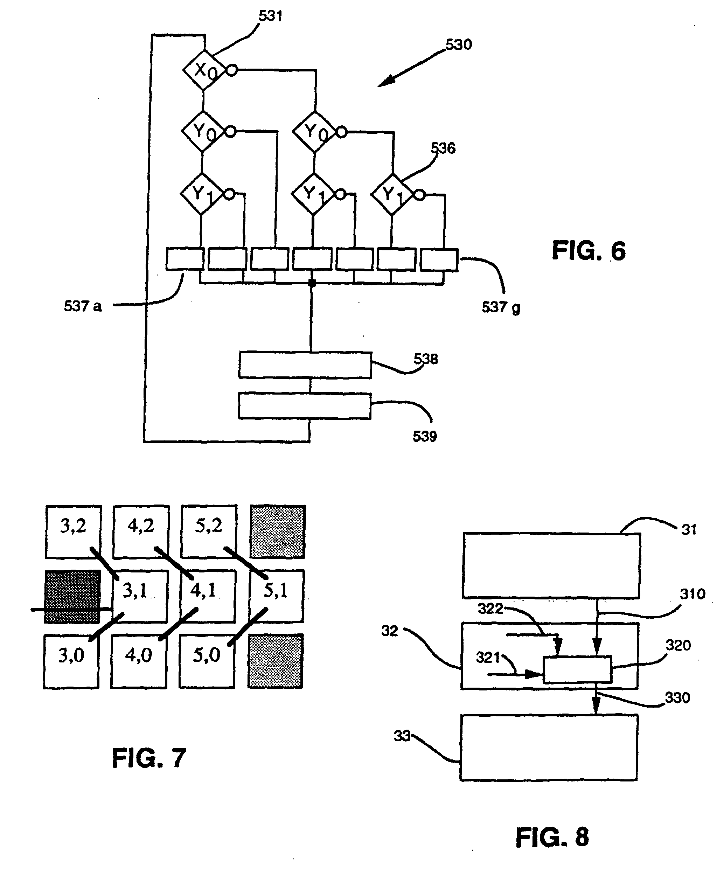

La figure 5 montre un exemple de réseau comportant des moyens pour propager le gène de chaque cellule à travers tout le réseau et illustrant la possibilité de désactiver toutes les cellules de la ligne et de la colonne qui correspondent aux coordonnées d'une cellule défectueuse. Le réseau 500 comprend 7 x 5 cellules identiques, par exemple du type montré à la figure 3, reliées par une connexion 501 à une machine de décision binaire 520. Cette machine de décision binaire est capable de fournir, en succession, le gène de chaque cellule à partir du génome stocké dans la mémoire RAM 521. La machine de décision binaire 520 comprend encore un compteur de position 522, qui détermine les coordonnées de la cellule considérée, un multiplexeur 523, qui fournit alternativement sur sa sortie W la valeur de l'abcisse X ou de l'ordonnée Y de ladite cellule, un multiplexeur 524, un compteur de programme 525 et un registre 526 pour stocker le gène de la cellule considérée. L'algorithme de génération du gène de chaque cellule est représenté à la figure 6. Cette représentation est analogue à celle de la figure 1. On y retrouve des losanges, représentant des opérations de test de la variable figurant à l'intérieur, et des rectangles, représentant des opérations de type *"Faire"*. Les rectangles 537a à 537g représentent l'opération "*Charger les N bits du gène de la cellule de coordonnées X, Y"*, le rectangle 538 représente l'opération *"Décaler le registre* 526 de *N bits*" et le rectangle 539 représente l'opération *"Incrémenter les valeurs de X et de Y*". Cet algorithme est exécuté par la machine de décision binaire 520. Celle-ci génère, en premier lieu, le gène de la cellule de coordonnées (0,0), puis celui de la cellule de coordonnées (1,0) et ainsi de suite jusqu'au gène de la cellule de coordonnées (5,3). Les gènes stockés successivement dans le registre 526 sont, à chaque cycle de la machine de décision binaire 520, transférés dans le registre à décalage (identique au registre à décalage 512 de la cellule 510) de la première cellule de coordonnées (5,3), tandis que le gène précédemment inscrit dans le registre à décalage de cette cellule est transféré dans le registre à décalage de la cellule de coordonnées (4,3) puis, ainsi de suite jusqu'à ce que le registre à décalage de la dernière cellule de coordonnées (0,0) reçoive le mot représentant son gène.

Chaque cellule, telle la cellule 510 représentée plus en détail, comprend un registre à décalage 512 stockant le gène de cette cellule, un bloc 513 constitué d'éléments fonctionnels (tel un circuit multiplexeur) et de moyens de programmation (tels des interrupteurs), un circuit de test 514 qui teste le bon fonctionnement desdits éléments fonctionnels et desdits interrupteurs, un circuit de génération d'un signal de panne 515 et des moyens de désactivation 516 de la cellule lorsqu'un signal de panne est présent. Lesdits moyens de désactivation ont pour effet de rendre la cellule parfaitement transparente dans le réseau; ils peuvent être constitués par des interrupteurs qui établissent des court-circuits entre les bornes de la cellule de telle manière que tous les signaux présents sur ces bornes soient transférés sur les bornes correspondantes des cellules voisines. Par ailleurs, le signal de panne d'une cellule défectueuse est transmis à toutes les cellules de la même ligne et de la même colonne afin que ces dernières puissent se désactiver à leur tour. Ces cellules désactivées apparaissent en grisé dans la figure 5. Le signal de panne d'une cellule est également transmis à la machine de décision binaire 520 qui, dès réception, réitère la programmation du réseau. Il est clair que le réseau doit, initialement, être constitué de plus de cellules que nécessaire pour pouvoir permettre la désactivation des cellules défectueuses et la reprogrammation du système.

La désactivation de toutes les cellules se trouvant sur la même ligne et la même colonne que la cellule défectueuse est un mécanisme simple mais quelque peu dispendieux. La figure 7 montre une autre variante selon laquelle seule la cellu'e en panne (en grisé foncé sur la figure) se trouve désactivée. Sa fonction est reprise par la cellule voisine (à droite sur la figure) et ainsi de suite jusqu'au bout de la ligne. Un tel mécanisme diminue le nombre de cellules à désactiver en cas de panne mais est plus difficile à mettre en oeuvre que le mécanisme décrit précédemment.

Une autre variante consiste à ne désactiver que les cellules de la ligne, ou de la colonne, qui contient une cellule défectueuse. La figure 8 montre un exemple de circuit pouvant être incorporé sur le chemin des entrées d'une cellule et permettant de désactiver ces entrées. Par raison de simplification, une seule entrée est représentée; il est clair, cependant, que le même circuit doit être présent sur chaque entrée. La sortie 310 de la cellule 31 est connectée à une entrée d'un multiplexeur 320, dont une deuxième entrée est connectée à l'entrée 322 de la cellule 32; laquelle entrée 322 correspond à la sortie 310 de la cellule 31. Le multiplexeur 320 est commandé par le signal de panne de la cellule 32 et connecte, en fonction de ce signal de panne, l'une ou l'autre de ses entrées à la sortie 330, qui est la sortie de la cellule 32 analogue à la sortie 310 de la cellule 31.

Dans ce qui précède, il a été considéré qu'une cellule défectueuse élaborait et transmettait elle-même son signal de panne. Or, il n'est pas improbable que ses moyens d'élaboration et de transmission du signal de panne soient, eux-mêmes, défectueux. Pour éviter une telle situation, il est avantageux de prévoir que chaque cellule teste d'autres cellules, telles que les cellules qui lui sont adjacentes, par exemple.

Bien d'autres algorithmes de reconfiguration que ceux décrits précédemment peuvent être utilisés. A titre d'exemple, on se reportera à l'article de Mengly Chean et Jose A. B. Fortes intitulé "A Taxonomy of Reconfiguration Techniques for Fault-Tolerant Processor Arrays" et paru dans la revue "Computer" de janvier 1990.

## Revendications

1. Système électronique intégré comportant un réseau matriciel de cellules identiques, chaque cellule comprenant une pluralité d'éléments fonctionnels et des premiers moyens de connexion pour connecter lesdits éléments fonctionnels de telle sorte que ladite cellule soit apte à réaliser une fonction donnée, et des seconds moyens de connexion pour connecter chaque cellule à ses voisines; ledit système électronique étant **caractérisé en ce qu'**il comporte en outre:
- des moyens de stockage pour stocker une première information représentant les fonctions de l'ensemble des cellules constituant ledit réseau;
- des moyens d'extraction pour extraire, à partir de ladite première information stockée, des deuxièmes informations, chacune desdites deuxièmes informations représentant la fonction d'une seule desdites cellules du réseau; et
- des moyens de programmation pour programmer, dans chaque cellule, lesdits premiers et lesdits seconds moyens de connexion à partir desdites deuxièmes informations, définissant ainsi la fonction de ladite cellule dans le réseau et **en ce que** lesdits moyens d'extraction extraient lesdites deuxièmes informations en combinant ladite première information et un code représentatif de la position de ladite cellule dans le réseau, de manière que ledit système dispose d'une capacité de reprogrammation en cas de panne d'une ou plusieurs des cellules dans le réseau.

2. Système électronique selon la revendication 1 **caractérisé en ce que** lesdits moyens de stockage sont communs à toutes les cellules du réseau

3. Système électronique selon la revendication 1, **caractérisé en ce que** lesdits moyens de stockage appartiennent à chacune des cellules du réseau.

4. Système électronique selon l'une quelconque des revendications 1 à 3, **caractérisé en ce que** chaque cellule comprend:
- des moyens de test pour tester le fonctionnement des éléments fonctionnels et des moyens de connexion des cellules qui lui sont voisines et pour transmettre à ces dernières un signal de panne en cas de mauvais fonctionnement;
- des moyens de désactivation qui, en réponse audit signal de panne, désactive ladite cellule en court-circuitant ses entrées et ses sorties de telle sorte qu'elle soit transparente dans le réseau; et
- des moyens de reconfiguration pour reprogrammer une autre cellule de manière à ce que cette dite autre cellule puisse réaliser la fonction préalablement assignée à la cellule défectueuse.

5. Système électronique selon l'une quelconque des revendications 1 à 3, **caractérisé en ce que** chaque cellule comprend:
- des moyens de test pour tester le fonctionnement de ses éléments fonctionnels et de ses moyens de connexion et pour transmettre, aux cellules qui lui sont voisines, un signal de panne en cas de mauvais fonctionnement de l'une desdites cellules voisines;
- des moyens de désactivation qui, en réponse audit signal de panne, désactive la cellule défectueuse en court-circuitant ses entrées et ses sorties de telle sorte qu'elle soit transparente dans le réseau; et
- des moyens de reconfiguration pour reprogrammer une autre cellule de manière à ce que cette dite autre cellule puisse réaliser la fonction préalablement assignée à la cellule défectueuse.

6. Système électronique selon la revendication 4 ou la revendication 5, **caractérisé en ce que** ledit signal de panne d'une cellule défectueuse est transmis à toutes les cellules de la ligne et de la colonne de cette cellule défectueuse et **en ce que** les moyens de désactivation de ces cellules sont prévus de manière à les désactiver en réponse audit signal de panne.

7. Système électronique selon la revendication 4 ou la revendication 5, **caractérisé en ce que** ledit signal de panne d'une cellule défectueuse est transmis à toutes les cellules de la ligne de cette cellule défectueuse et **en ce que** les moyens de désactivation de ces cellules sont prévus de manière à les désactiver en réponse audit signal de panne.

8. Système électronique selon la revendication 4 ou la revendication 5, **caractérisé en ce que** ledit signal de panne d'une cellule défectueuse est transmis à toutes les cellules de la colonne de cette cellule défectueuse et **en ce que** les moyens de désactivation de ces cellules sont prévus de manière à les désactiver en réponse audit signal de panne.

9. Système électronique selon l'une quelconque des revendications 1 à 8, **caractérisé en ce que** lesdits éléments fonctionnels comprennent des blocs logiques.

10. Système électronique selon l'une quelconque des revendications 1 à 8, **caractérisé en ce que** lesdits éléments fonctionnels comprennent des blocs analogiques.

## Claims

1. Integrated electronic system comprising a matrix network of identical cells, each cell comprising a plurality of functional elements and first connection means for connecting said functional elements such that said cell is capable of implementing a given function, and second connection means for connecting each cell to its neighbours; said electronic system being **characterised in that** it furthermore comprises:
- storage means for storing a first piece of data which represents the functions of the entirety of the cells forming said network;
- extraction means for extracting, from said first stored piece of data, second pieces of data, each of said second pieces of data representing the function of a single one of said cells of the network; and
- programming means for programming, in each cell, said first and said second connection means from said second pieces of data, thus defining the function of said cell in the network, and **in that** said extraction means extract said second pieces of data by combining said first piece of data and a code which is representative of the position of said cell in the network, in such a way that said system may be reprogrammed in case of failure of one or more cells of said matrix.

2. Electronic system according to claim 1, **characterised in that** said storage means are communal to all the cells of the network.

3. Electronic system according to claim 1, **characterised in that** said storage means belong to each of the cells of the network.

4. Electronic system according to any of the claims 1 to 3, **characterised in that** each cell comprises:
- test means for testing the functioning of the functional elements and of the connection means of the cells which are adjacent thereto and for transmitting to the latter a failure signal in the case of malfunction;
- deactivation means which, in response to said failure signal, deactivate said cell by short-circuiting its inputs and its outputs such that it is transparent in the network; and
- reconfiguration means for re-programming another cell so that this said other cell is able to implement the function which was previously assigned to the defective cell.

5. Electronic system according to any of the claims 1 to 3, **characterised in that** each cell comprises:
- test means for testing the functioning of its functional elements and of its connection means and for transmitting, to the cells which are adjacent thereto, a failure signal in the case of malfunction of one of said adjacent cells;
- deactivation means which, in response to said failure signal, deactivate the defective cell by short-circuiting its inputs and its outputs such that it is transparent in the network; and
- reconfiguration means for re-programming another cell so that this said other cell is able to implement the function which was previously assigned to the defective cell.

6. Electronic system according to claim 4 or claim 5, **characterised in that** said failure signal from a defective cell is transmitted to all the cells of the line and of the column of this defective cell, and **in that** the deactivation means of these cells are provided so as to deactivate them in response to said failure signal.

7. Electronic system according to claim 4 or claim 5, **characterised in that** said failure signal from a defective cell is transmitted to all the cells of the line of this defective cell, and **in that** the deactivation means of these cells are provided so as to deactivate them in response to said failure signal.

8. Electronic system according to claim 4 or claim 5, **characterised in that** said failure signal from a defective cell is transmitted to all the cells of the column of this defective cell, and **in that** the deactivation means of these cells are provided so as to deactivate them in response to said failure signal.

9. Electronic system according to any of the claims 1 to 8, **characterised in that** said functional elements comprise logic blocks.

10. Electronic system according to any of the claims 1 to 8, **characterised in that** said functional elements comprise analogue blocks.

## Patentansprüche

1. Integriertes elektronisches System, das ein matrixförmiges Gitter aus gleichen Zellen umfaßt, wovon jede mehrere funktionale Elemente und erste Verbindungsmittel zum Verbinden der funktionalen Elemente in der Weise, daß die Zelle eine gegebene Funktion ausführen kann, sowie zweite Verbindungsmittel zum Verbinden jeder Zelle mit ihren Nachbarn umfaßt; wobei das elektronische System **dadurch gekennzeichnet ist, daß** es außerdem umfaßt:
- Speichermittel zum Speichern erster Informationen, die die Funktionen der Gesamtheit der das Gitter bildenden Zellen repräsentieren;
- Extraktionsmittel, die anhand der gespeicherten ersten Informationen zweite Informationen extrahieren, wobei jede der zweiten Informationen die Funktion einer einzigen dieser Zellen des Gitters repräsentiert; und
- Programmierungsmittel, die in jeder Zelle die ersten und zweiten Verbindungsmittel anhand der zweiten Informationen programmieren, wodurch die Funktion dieser Zelle im Gitter definiert wird, **dadurch gekennzeichnet, daß** die Extraktionsmittel die zweiten Informationen dadurch extrahieren, daß sie die ersten Informationen mit einem die Position der Zelle im Gitter repräsentierenden Code so kombinieren, dass das System im Falle einer Panne einer oder mehreren Zellen im Gitter über die Fähigkeit der Umprogrammierung verfügt.

2. Elektronisches System nach Anspruch 1, **dadurch gekennzeichnet, daß** die Speichermittel allen Zellen im Gitter gemeinsam sind.

3. Elektronisches System nach Anspruch 1, **dadurch gekennzeichnet, daß** die Speichermittel zu jeder der Zellen im Gitter gehören.

4. Elektronisches System nach einem der Ansprüche 1 bis 3, **dadurch gekennzeichnet, daß** jede Zelle umfaßt:
- Testmittel zum Testen der Funktion der funktionalen Elemente und der Verbindungsmittel der ihr benachbarten Zellen und zum Übertragen eines Fehlersignals an diese letzteren im Fall eines schlechten Betriebs;
- Deaktivierungsmittel, die in Reaktion auf das Fehlersignal diese Zelle deaktivieren, indem sie ihre Eingänge und ihre Ausgänge kurzschließen, so daß sie in dem Gitter durchlässig ist; und
- Rekonfigurationsmittel, die eine weitere Zelle in der Weise umprogrammieren, daß diese weitere Zelle die Funktion ausführen kann, die vorher dieser fehlerhaften Zelle zugewiesen war.

5. Elektronisches System nach einem der Ansprüche 1 bis 3, **dadurch gekennzeichnet, daß** jede Zelle umfaßt:
- Testmittel zum Testen der Funktion ihrer funktionalen Elemente und ihrer Verbindungselemente und zum Übertragen eines Fehlersignals an die ihr benachbarten Zellen im Fall eines schlechten Betriebs einer der benachbarten Zellen;
- Deaktivierungsmittel, die in Reaktion auf das Fehlersignal die fehlerhafte Zelle deaktivieren, indem sie ihre Eingänge und ihre Ausgänge kurzschließen, so daß sie im Gitter durchlässig ist; und
- Rekonfigurationsmittel, die eine weitere Zelle so umprogrammieren, daß diese weitere Zelle die Funktion ausführen kann, die vorher der fehlerhaften Zelle zugewiesen war.

6. Elektronisches System nach Anspruch 4 oder Anspruch 5, **dadurch gekennzeichnet, daß** das Fehlersignal einer fehlerhaften Zelle an alle Zellen der Zeile und der Spalte dieser fehlerhaften Zelle übertragen wird und daß die Deaktivierungsmittel dieser Zellen so beschaffen sind, daß sie diese in Reaktion auf das Fehlersignal deaktivieren.

7. Elektronisches System nach Anspruch 4 oder Anspruch 5, **dadurch gekennzeichnet, daß** das Fehlersignal einer fehlerhaften Zelle an alle Zellen der Zeile dieser fehlerhaften Zelle übertragen wird und daß die Deaktivierungsmittel dieser Zellen so beschaffen sind, daß sie diese in Reaktion auf das Fehlersignal deaktivieren.

8. Elektronisches System nach Anspruch 4 oder Anspruch 5, **dadurch gekennzeichnet, daß** das Fehlersignal einer fehlerhaften Zelle an alle Zellen der Spalte dieser fehlerhaften Zelle übertragen wird und daß die Deaktivierungsmittel dieser Zellen so beschaffen sind, daß sie diese in Reaktion auf das Fehlersignal deaktivieren.

9. Elektronisches System nach einem der Ansprüche 1 bis 8, **dadurch gekennzeichnet, daß** die funktionalen Elemente logische Blöcke enthalten.

10. Elektronisches System nach einem der Ansprüche 1 bis 8, **dadurch gekennzeichnet, daß** die funktionalen Elemente analoge Blöcke enthalten.
